# EUROPÄISCHE PATENTANMELDUNG

(11) **EP 2 210 688 A1**
(43) Veröffentlichungstag der Anmeldung: **28.07.2010**
(21) Anmeldenummer: 09000800.4
(22) Anmeldetag: 21.01.2009
(51) Int. Cl.: B22D 27/04, C30B 11/00, C30B 29/52, F01D 5/14

(54) **Bauteil mit unterschiedlichem Gefüge und Verfahren zur Herstellung**

(71) Anmelder: Siemens Aktiengesellschaft, 80333 München (DE)
(72) Erfinder: Harders, Harald, 45468 Mülheim a.d. Ruhr (DE); Lüsebrink, Oliver, 58456 Witten (DE)

(57) **Zusammenfassung**

Einkristalline oder stängelförmige Turbinenschaufeln sind schwierig herzustellen.
Die erfindungsgemäße Turbinenschaufel weist verschiedene Strukturen für verschiedene Bereiche der Turbinenschaufel auf, wobei der Schaufelblattbereich immer eine stängelförmige oder einkristalline Struktur aufweist und die anderen Bereiche davon abweichen können.

## Beschreibung

Die Erfindung betrifft ein Bauteil mit einem Gefüge, das in verschiedenen Stellen verschieden ist und Verfahren zur Herstellung.

Bei der einkristallinen (SX) oder stängelkristallinen (DS) gerichteten Erstarrung von Gasturbinenschaufeln stellt eine fehlerfreie Erstarrung des Schaufelfußes aufgrund des begrenzten thermischen Gradienten und der komplexen Geometrie im Feingussofen eine Herausforderung dar.

Um den Schaufelfuß gerichtet (SX, DS) erstarren zu lassen, ist ein sehr langer und kostenintensiver Prozesszyklus erforderlich. Dennoch fällt eine nicht unerhebliche Anzahl an Schaufeln durch Kornstrukturfehler (z.B. Neukörner) im Fuß aus. Weiterhin ist die SX- bzw. DS-Erstarrung im Hinblick auf die Schaufelgröße begrenzt, wodurch die Vorteile von gerichtet erstarrten Turbinenschaufeln in den hinteren Turbinenlaufreihen nicht ausgenutzt werden können.

Die gerichtete Erstarrung erfolgt nach heutigem Stand der Technik im sogenannten Bridgeman-Verfahren. Hier werden Schaufeln bis zu einer durch den thermischen Gradienten im Gienofen begrenzten Größe stängelkristallin (DS) oder einkristallin (SX) gerichtet erstarrt. Für die fehlerfreie Erstarrung des Schaufelfußes ist aber ein sehr langer Prozesszyklus erforderlich.

Zur Umgehung dieser Limitierungen werden auf anlagentechnischer Seite Anstrengungen unternommen, den wirkenden thermischen Gradienten im Ofen zu verbessern (z.B. durch Gaskühlung, Kühlung in einem keramischen Fluidbett oder in einer flüssigen Metallschmelze (LMC)). Weiterhin wurden Legierungen im Hinblick auf ihre Gießbarkeit optimiert, was aber für gewöhnlich mit einem Kompromiss in den mechanischen Eigenschaften erkauft werden musste.

Die Aufgabe der Erfindung ist es oben genannte Probleme zu überwinden.

Die Aufgabe wird gelöst durch ein Bauteil gemäß Anspruch 1, nämlich durch kolumnare (DS) oder konventionelle (CC) Erstarrung in einem zweiten Bereich bei einkristalliner (SX) Erstarrung eines ersten Bereichs und Verfahren gemäß Ansprüchen 15, 16, 17.

In den Unteransprüchen sind weitere vorteilhafte Maßnahmen aufgelistet, die beliebig miteinander kombiniert werden können, um weitere Vorteile zu erzielen.

Es wurde festgestellt, dass eine SX- bzw. DS-Struktur aufgrund einer im Betrieb niedrigeren Beanspruchungstemperatur und eines unterschiedlich wirkenden Belastungskollektives im zweiten Bereich nicht benötigt wird. Dazu können jedoch chemische Elemente in der Legierung erforderlich sein, die eine für SX/DS-Erstarrung gedachte Legierung nicht unbedingt beinhaltet.

Dazu ist die Legierung im zweiten Bereich (Schaufelfuß) vorzugsweise zu modifizieren bzw. ist für das gesamte Bauteil eine Legierung zu verwenden, die der Beanspruchung sowohl im zweiten Bereich (Fuß) als auch im ersten Bereich (Blatt) Rechnung tragen kann.

Die gesamte Erstarrung solch einer Schaufel kann in situ in einem Prozess nach den drei folgenden technischen Merkmalen erfolgen:
1. DS-SX-Erstarrung des Schaufelblattes (1. Bereich) mit reduzierter Vormaterialmenge (1. Legierung für das Schaufelblatt, d.h. die Menge für eine Schmelze die nur das Schaufelblatt ergibt, aber nicht den Schaufelfuß);
   dann Umschaltung der Prozessparameter und Zugabe einer zweiten Legierung (verschieden von 1. Legierung) zur Erstarrung des Schaufelfußes (2. Bereich).
2. DS-SX-Erstarrung des Schaufelblattes (1. Bereich) mit gesamter Vormaterialmenge (Legierung für das Blatt, Schaufelplattform und Schaufelfuß, Menge für Schmelze ausreichend für Schaufelblatt und Schaufelfuß); dann Umschaltung der Prozessparameter und Zugabe zusätzlicher Legierungselemente zu der Legierung des Schaufelblatts, also der noch nicht erstarrten Schmelze der gesamten Vormaterialmenge;
   Erstarrung des Schaufelfußes (2. Bereich).
3. DS-SX-Erstarrung des Schaufelblattes (1. Bereich) mit gesamter Vormaterialmenge (eine einzige Legierung ist sowohl für das Blatt als auch für den Fuß geeignet und in ausreichender Menge);
   dann Umschaltung der Prozessparameter und Erstarrung des Schaufelfußes (2. Bereich).

Vormaterialmenge ist die Menge an Material aus einer Legierung oder aus zwei Legierungen, die benötigt wird, um das gesamte Bauteil bzw. Schaufel vollständig abzugießen.

Es zeigen:

| | |
|---|---|
| Figur 1 bis 8 | Ausführungsbeispiele eines Bauteils, |
| Figur 9 | eine Gasturbine, |
| Figur 10 | eine Turbinenschaufel, |
| Figur 11 | eine Liste von Superlegierungen. |

Die Beschreibung und die Figuren stellen nur Ausführungsbeispiele der Erfindung dar.
Die Erfindung wird nur beispielhaft anhand einer Turbinenschaufel 120, 130 erläutert.

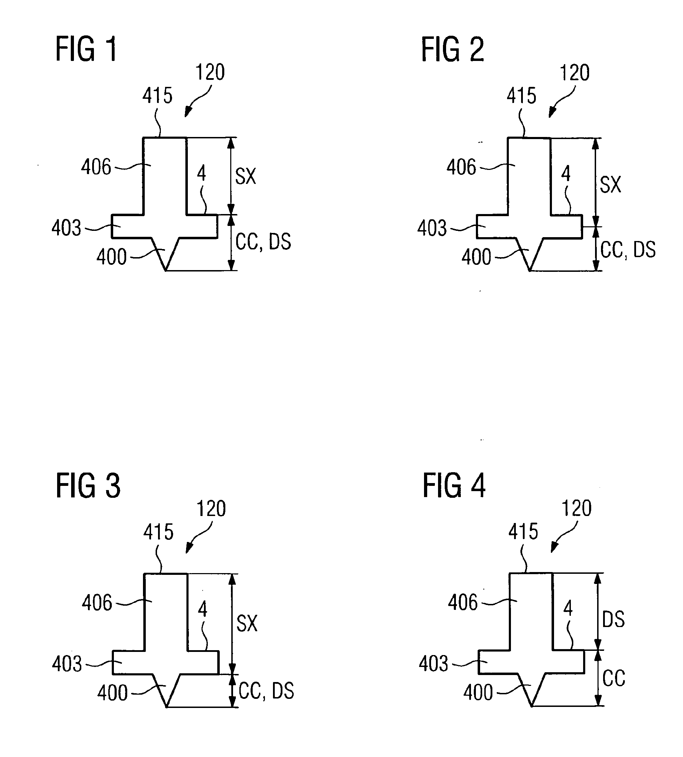

In Figur 1 ist eine Turbinenschaufel 120 dargestellt mit einem Schaufelblattbereich 406 (erster Bereich 406) einer Schaufelplattform 403 (erster 406 und/oder zweiter Bereich 403) und einem Befestigungsbereich 400 (zweiter Bereich).

Der Schaufelblattbereich 406 besteht vorzugsweise aus einer einkristallinen Struktur (SX). Die einkristalline Struktur (SX) erstreckt sich von der Schaufelspitze 415 und vorzugsweise bis zur Oberseite 4 der Schaufelplattform 403.

Vorzugsweise weisen die Schaufelplattform 403 und zumindest der Befestigungsbereich 400 eine andere Struktur, also keine einkristalline Struktur auf. Dies können kolumnar erstarrte stängelförmige Kristalle (DS) sein oder eine ungerichtete Struktur (CC-Struktur).

Je nach mechanischer Anforderung kann sich die einkristalline Struktur (SX) von dem Schaufelblatt 406 auch bis zu einer gewissen Dicke in die Schaufelplattform 403 hinein erstrecken. Dann beginnt innerhalb der Schaufelplattform 403 eine DS-oder CC-Struktur (Fig. 2).

Bei besonders hohen Belastungen (thermisch, mechanisch) kann auch die gesamte Schaufelplattform 403 einkristallin erstarrt sein, so dass nur der Befestigungsbereich 400 eine CC- oder DS-Struktur aufweist, wie sie in Figur 3 dargestellt ist.

Figur 4 zeigt ein weiteres Ausführungsbeispiel der Erfindung, wobei Figur 4 ein analoges Beispiel zur Figur 1 darstellt, nämlich dass die SX-Struktur im Schaufelblattbereich 406 durch eine DS-Struktur ersetzt ist und die nachfolgenden Bereiche eine Struktur mit CC-Struktur aufweisen. In analoger Weise gilt dies auch für eine DS-CC-Struktur gemäß den Figuren 2 und 3.

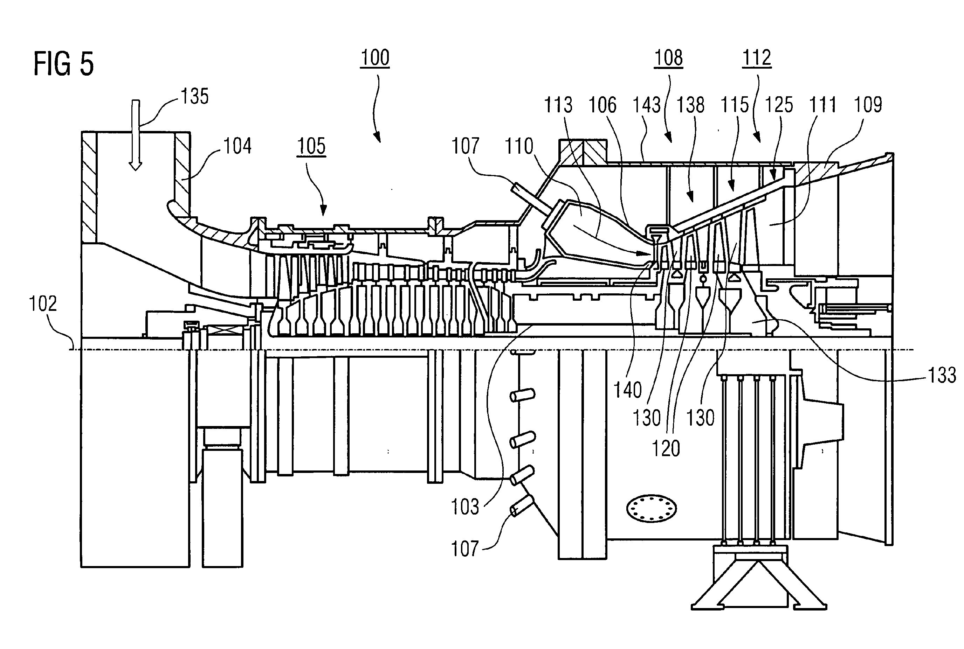

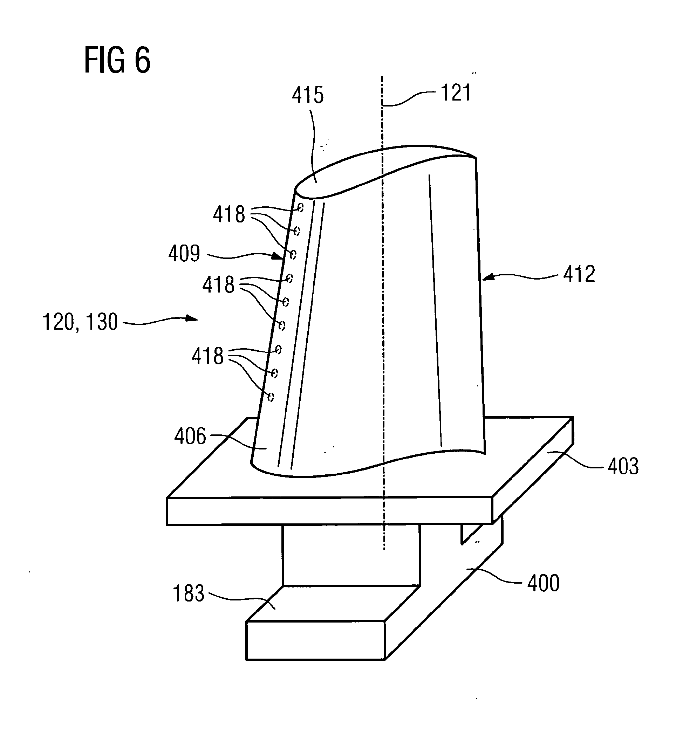

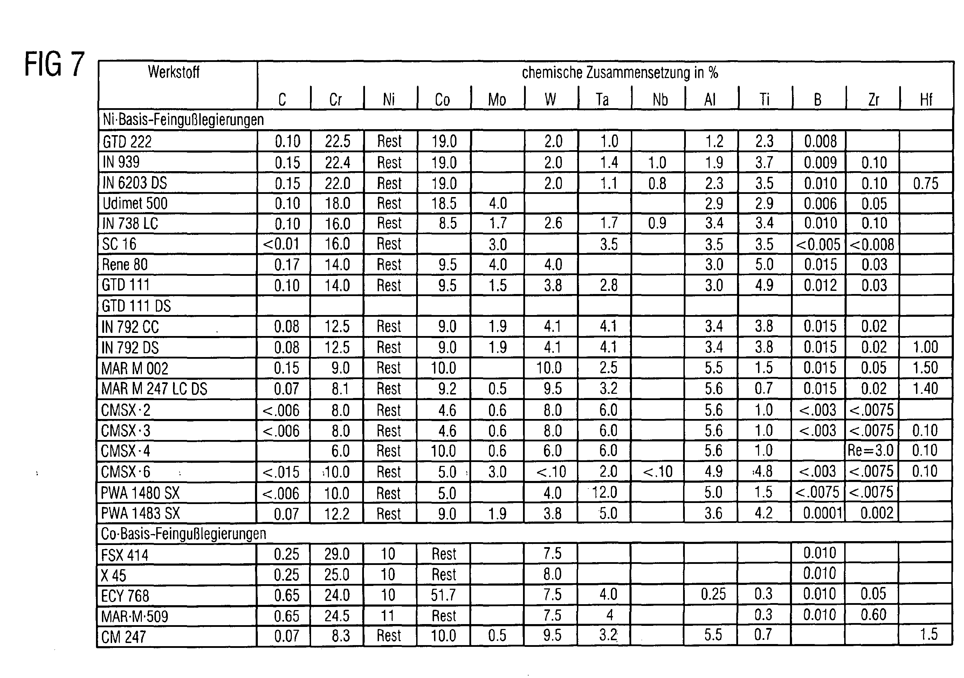

Ebenso kann das Schaufelblatt 406 eine SX Struktur, die Schaufelplattform 403 eine DS-Struktur und der Schaufelfuß 400 eine CC-Struktur aufweisen (Fig. 5).

Wenn drei Strukturen (SX, DS, CC) vorhanden sind können die sich über verschiedene Bereiche erstrecken:

| | |
|---|---|
| Fig. 6: | SX im Schaufelblatt 406, SX teilweise in der Schaufelplattform 403, Rest Schaufelplattform 403 ist DS, Schaufelfuß 400 = CC |
| Fig. 7: | SX im Schaufelblatt 406 DS in der Schaufelplattform 403 und DS nur teilweise im Schaufelfuß 400 Schaufelfuß 400 = CC |
| Fig. 8: | SX ein Schaufelblatt 406 und SX nur teilweise in der Schaufelplattform 403 DS in Schaufelplattform 403 und DS nur teilweise ein Schaufelfuß 400 CC ein Schaufelfuß (Rest). |

Ebenso kann bei SX im Schaufelblatt 406 die Schaufelblattform 403 eine DS und CC Struktur (in Richtung Schaufelfuß 400 gesehen) oder eine SX, DS, CC Struktur (in Richtung Schaufelfuß 400 gesehen) aufweisen, wobei der Schaufelfuß jeweils eine CC Struktur aufweist.

Die Vorteile der unterschiedlichen Gefüge sind:
- Reduzierung des Ausschusses bei der Herstellung von SX-oder DS-Bauteilen
- deutliche Kostenreduzierung bei der Verfahrensführung
- Nutzbarmachung von SX-DS-Strukturen für größere Schaufeln und damit verbunden eine möglich Erhöhung des Turbinenwirkungsgrades
- lokale Optimierung des Schaufelfußes bzw. Schaufelblattes im Hinblick auf das lokal wirkende
- Beanspruchungskollektiv.

Die Figur 9 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet (Fig. 11).
Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus ZrO₂ Y₂C₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 10 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrA1X; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.
Die Dichte liegt vorzugsweise bei 95% der theoretischen Dichte.
Auf der MCrA1X-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10A1-0,6Y auf. Neben diesen kobaltbasierten Schutzbeschichtungen werden auch vorzugsweise nickelbasierte Schutzschichten verwendet wie Ni-10Cr-12A1-0,6Y-3Re oder Ni-12Co-21Cr-11A1-0,4Y-2Re oder Ni-25Co-17Cr-10A1-0,4Y-1,5Re.

Auf der MCrAlX kann noch eine Wärmedämmschicht vorhanden sein, die vorzugsweise die äußerste Schicht ist, und besteht beispielsweise aus ZrO₂ Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrA1X-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrA1X-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

## Patentansprüche

1. Bauteil,
das aufweist:
zumindest einen ersten Bereich (403, 406) und
zumindest einen zweiten Bereich (400, 403),
wobei zumindest der zweite Bereich (400, 403) eine niedergeordnete Struktur gegenüber dem ersten Bereich (403, 406) aufweist,
wobei eine stängelförmige Struktur (DS) und eine ungerichtet erstarrte Struktur (CC) eine niedergeordnete Struktur gegenüber einer einkristallinen Struktur (SX) darstellen und
eine CC-Struktur eine untergeordnete Struktur gegenüber einer DS-Struktur und einer einkristallinen Struktur (SX) darstellt.

2. Bauteil nach Anspruch 1,
das eine Turbinenschaufel (120, 130) darstellt,
die (120, 130) aufweist
einen Schaufelblattbereich (406) als ersten Bereich, eine Schaufelplattform (403) als ersten und/oder zweiten Bereich
und einen Befestigungsbereich (400) als zweiten Bereich, wobei der Schaufelblattbereich (406) eine SX- oder DS-Struktur aufweist und
zumindest der Befestigungsbereich (400) eine niedergeordnete Struktur gegenüber dem Schaufelblattbereich (406) aufweist.

3. Bauteil nach Anspruch 1 oder 2,
wobei der erste Bereich (406),
insbesondere der gesamte erste Bereich (406),
eine einkristalline Struktur (SX) aufweist,
insbesondere der gesamte Schaufelblattbereich (406) eine SX-Struktur aufweist.

4. Bauteil nach Anspruch 1 oder 2,
bei dem der erste Bereich (406),
insbesondere der gesamte erste Bereich (406),
eine stängelförmige Struktur (DS) aufweist,
insbesondere der gesamte Schaufelblattbereich (406) eine DS-Struktur aufweist.

5. Turbinenschaufel nach Anspruch 3,
wobei sich die einkristalline Struktur (SX) bis zu einer gewissen Dicke, aber höchstens teilweise in die Schaufelplattform (403) erstreckt.

6. Turbinenschaufel nach Anspruch 3,
bei der sich die einkristalline Struktur (SX) durch die gesamte Schaufelplattform (403) erstreckt.

7. Turbinenschaufel nach Anspruch 4,
bei der sich die DS-Struktur bis zu einer gewissen Dicke, aber höchstens teilweise in die Schaufelplattform (403) erstreckt.

8. Turbinenschaufel nach Anspruch 4,
bei der sich die DS-Struktur durch die gesamte Schaufelplattform (403) erstreckt.

9. Bauteil nach Anspruch 1, 2, 3, 4, 5, 6, 7 oder 8,
bei dem der zweite Bereich (400),
insbesondere der Schaufelbefestigungsbereich (400),
eine ungerichtet erstarrte Struktur aufweist (CC) aufweist.

10. Bauteil nach Anspruch 1, 2, 3, 5 oder 6
bei dem der zweite Bereich (400),
insbesondere der Befestigungsbereich (400) eine stängelförmige Struktur (DS) aufweist.

11. Turbinenschaufel nach Anspruch 2, 3, 4 oder 9,
bei der die Schaufelplattform (403) eine andere Struktur aufweist als der Schaufelblattbereich (406).

12. Turbinenschaufel nach Anspruch 2, 3 oder 4,
bei der die Schaufelplattform (403) höchstens teilweise dieselbe Struktur wie der Schaufelblattbereich (406) aufweist.

13. Turbinenschaufel nach Anspruch 2, 3 oder 4,
bei der die Schaufelplattform (403) dieselbe Struktur wie der Schaufelblattbereich (406) aufweist.

14. Bauteil nach Anspruch 1, 2, 3 oder 4,
das zumindest im zweiten Bereich (400) eine andere Legierung aufweist als im ersten Bereich (406).

15. Verfahren
zur Herstellung eines Bauteils (120, 130),
das zumindest einen ersten Bereich (403, 406) und zumindest einen zweiten Bereich (400, 403) aufweist,
wobei zumindest der zweite Bereich (400, 403) eine niedergeordnete Struktur gegenüber dem ersten Bereich (403, 406) aufweist,
wobei eine stengelförmige Struktur (DS) und eine ungerichtet erstarrte Struktur (CC) eine niedergeordnete Struktur gegenüber einer einkristallinen Struktur (SX) darstellen und
eine CC-Struktur eine untergeordnete Struktur gegenüber einer DS-Struktur und einer einkristallinen Struktur (SX) darstellt,
wobei zuerst der zumindest erste Bereich (403, 406) mit reduzierter Vormaterialmenge einer ersten Legierung erstarren gelassen wird und
dann eine Umschaltung der Prozessparameter und Zugabe der restlichen Vormaterialmenge einer zweiten Legierung zur Erstarrung des zweiten Bereichs (400, 403) erfolgt.

16. Verfahren
zur Herstellung eines Bauteils (120, 130),
das zumindest einen ersten Bereich (403, 406) und zumindest einen zweiten Bereich (400, 403) aufweist,
wobei zumindest der zweite Bereich (400, 403) eine niedergeordnete Struktur gegenüber dem ersten Bereich (403, 406) aufweist,
wobei eine stengelförmige Struktur (DS) und eine ungerichtet erstarrte Struktur (CC) eine niedergeordnete Struktur gegenüber einer einkristallinen Struktur (SX) darstellen,
eine CC-Struktur eine untergeordnete Struktur gegenüber einer DS-Struktur und einer einkristallinen Struktur (SX) darstellt,
Bereitstellen und Schmelzen einer gesamten Vormaterialmenge für alle Bereiche (400, 403, 406),
wobei die Erstarrung des zumindest ersten Bereichs (403, 406) mit einem Teil der gesamten Vormaterialmenge erfolgt, wobei dann zur Herstellung des zweiten Bereichs eine Umschaltung der Prozessparameter und Zugabe zusätzlicher Legierungselemente in den restlichen, noch nicht erstarrten Teil der gesamten Vormaterialmenge erfolgt und Erstarrung des zumindest zweiten Bereichs (400, 403).

17. Verfahren
zur Herstellung eines Bauteils (120, 130),
das zumindest einen ersten Bereich (403, 406) und zumindest einen zweiten Bereich (400, 403) aufweist,
wobei zumindest der zweite Bereich (400, 403) eine niedergeordnete Struktur gegenüber dem ersten Bereich (403, 406) aufweist,
wobei eine stengelförmige Struktur (DS) und eine ungerichtet erstarrte Struktur (CC) eine niedergeordnete Struktur gegenüber einer einkristallinen Struktur (SX) darstellen,
eine CC-Struktur eine untergeordnete Struktur gegenüber einer DS-Struktur und einer einkristallinen Struktur (SX) darstellt,
Bereitstellen und Schmelzen einer gesamten Vormaterialmenge für alle Bereiche (400, 403, 406),
wobei zuerst der erste Bereich (403, 406) mit einem Teil der gesamten Vormaterialmenge erstarren gelassen wird und dann für die Herstellung des zweiten Bereichs (400, 403) eine Umschaltung der Prozessparameter und Erstarrung des zweiten Bereichs (4004, 403) mit dem restlichen Teil der gesamten Vormaterialmenge erfolgt.
